# EUROPEAN PATENT APPLICATION

(11) **EP 4 333 297 A1**
(43) Date of publication of application: **06.03.2024**
(21) Application number: 22804095.2
(22) Date of filing: 23.05.2022
(51) Int. Cl.: H03H 9/02, H03H 3/02

(54) **RESONATOR AND PREPARATION METHOD THEREFOR**

(30) Priority: 21.05.2021 CN 202110554828; 23.06.2021 CN 202110700269
(71) Applicant: Huawei Technologies Co., Ltd., Shenzhen, Guangdong 518129 (CN)
(72) Inventor: WU, Wei, Shenzhen, Guangdong 518129 (CN); LI, Hao, Shenzhen, Guangdong 518129 (CN); WANG, Jinhui, Shenzhen, Guangdong 518129 (CN); LI, Wei, Shenzhen, Guangdong 518129 (CN)
(74) Representative: Maiwald GmbH
(86) International application number: PCT/CN2022/094372
(87) International publication number: WO 2022/242776

(57) **Abstract**

A resonator is provided. The resonator includes a resonance layer, a substrate, and a barrier layer. The barrier layer is located on the substrate, and the barrier layer and the substrate form a cavity. The cavity is configured to accommodate the resonance layer. The barrier layer includes a top wall and a side wall, and an inner surface of the side wall surrounds the resonance layer. An outer surface of the side wall includes a groove, and the groove surrounds the side wall. Based on the foregoing implementation, complexity of a machining process of the resonator is reduced, machining costs are reduced, and reliability of the resonator is improved on the basis of ensuring miniaturization of the resonator.

## Description

This application claims priority to Chinese Patent Application No. 202110554828.1, filed on May 21, 2021 and entitled "CLOCK OSCILLATOR AND PREPARATION METHOD THEREOF", and to Chinese Patent Application No. 202110700269.0, filed on June 23, 2021 and entitled "RESONATOR AND PREPARATION METHOD THEREOF", which are incorporated herein by reference in their entireties.

### TECHNICAL FIELD

This application relates to the field of electronic components, and in particular, to a resonator and a preparation method thereof, and further to a clock oscillator, and a component and an electronic device including a clock oscillator.

### BACKGROUND

A clock oscillator is an important device in an electronic system, and provides a necessary clock frequency for the electronic system, so that the electronic system can perform various operations at the clock frequency, to implement normal working. The clock oscillator usually includes a resonator, an integrated circuit (integrated circuit, IC), and a base plate. Specifically, the clock oscillator includes modules such as an electrical/mechanical resonator, a feedback network, an amplification network, and an output network. Frequency selection is implemented by using a resonance characteristic of the circuit/mechanical resonator, to generate a frequency signal that oscillates periodically, that is, a clock signal.

An information and communications technology (Information and Communications Technology, ICT) may relate to different clock application scenarios, and different application scenarios have different requirements for clock signals. Moreover, as technologies develop, a volume of a resonator tends to be increasingly small, causing high complexity and high costs of a machining process of the resonator.

### SUMMARY

This application provides a resonator and a preparation method thereof, to reduce complexity of a machining process of the resonator, reduce machining costs, and improve reliability of the resonator on the basis of ensuring miniaturization of the resonator.

According to a first aspect, a resonator is provided. The resonator includes a resonance layer, a substrate, and a barrier layer. The barrier layer is located on the substrate, and the barrier layer and the substrate form a cavity. The cavity is configured to accommodate the resonance layer. The barrier layer includes a top wall and a side wall, and an inner surface of the side wall surrounds the resonance layer.

Based on the foregoing implementation, the barrier layer is added to the resonator, and etching of an etching material is effectively prevented by using the barrier layer, so that a size of the cavity is precisely controlled, complexity of a machining process of the resonator is reduced, machining costs are reduced, and reliability of the resonator is improved.

In a possible implementation, an outer surface of the side wall includes a groove, and the groove surrounds the side wall.

In a possible implementation, a trace of the groove is a closed curve in a direction from the top wall toward the substrate.

In a possible implementation, the side wall is obtained by machining a barrier material in the groove, the groove passes through a sacrificial layer between the top wall and the substrate, the sacrificial layer is configured to form the cavity, and the side wall is configured to prevent an etching material from entering the groove.

In a possible implementation, the barrier layer is obtained by depositing the barrier material on a surface of the sacrificial layer.

In a possible implementation, the barrier layer includes at least one etching through hole, and the at least one etching through hole is used to etch the sacrificial layer.

In a possible implementation, the resonance layer includes an upper electrode, a piezoelectric material layer, and a lower electrode, the substrate includes a first metal column and a second metal column, the first metal column and the second metal column are located outside the groove, a lead wire of the upper electrode passes through the side wall and is electrically connected to the second metal column, and a lead wire of the lower electrode passes through the side wall and is electrically connected to the first metal column.

In a possible implementation, the resonator further includes a sealing layer, and the sealing layer is formed on an outer surface of the barrier layer.

In a possible implementation, the first metal column passes through the sealing layer, and the first metal column is electrically connected to a first metal pad on a surface of the sealing layer away from the substrate. The second metal column passes through the sealing layer, and the second metal column is electrically connected to a second metal pad on the surface of the sealing layer away from the substrate.

In a possible implementation, the piezoelectric material layer is not in contact with the inner surface of the side wall.

According to a second aspect, a preparation method for a resonator is provided. The method includes: forming a resonance layer on a first surface of a substrate; forming a sacrificial layer on the first surface, to package the resonance layer inside the sacrificial layer; machining a groove on a second surface of the sacrificial layer away from the first surface, where the groove passes through the sacrificial layer, a trace of the groove on the first surface is a closed curve, and the groove surrounds the resonance layer; forming a barrier layer on the second surface and an inner surface of the groove; and removing a sacrificial layer surrounded by the barrier layer and the substrate, to cause the barrier layer and the substrate to form a cavity, where the cavity is configured to accommodate the resonance layer.

Based on the foregoing implementation, the barrier layer is added to the resonator, and etching of an etching material is effectively prevented by using the barrier layer, so that a size of the cavity is precisely controlled, complexity of a machining process of the resonator is reduced, machining costs are reduced, and reliability of the resonator is improved.

In a possible implementation, the barrier layer includes a top wall and a side wall, and the side wall is configured to prevent an etching material from entering the groove.

In a possible implementation, at least one etching through hole is machined on the barrier layer. The removing a sacrificial layer surrounded by the barrier layer and the substrate specifically includes: etching, through the at least one etching through hole, the sacrificial layer surrounded by the barrier layer and the substrate.

In a possible implementation, the resonance layer includes an upper electrode, a piezoelectric material layer, and a lower electrode.

In a possible implementation, the method further includes: machining a first metal column and a second metal column on the substrate, where the first metal column and the second metal column are located outside the groove, a lead wire of the upper electrode passes through the barrier layer and is electrically connected to the second metal column, and a lead wire of the lower electrode passes through the barrier layer and is electrically connected to the first metal column.

In a possible implementation, the method further includes: forming a sealing layer on an outer surface of the barrier layer.

In a possible implementation, the method further includes: machining a first metal pad and a second metal pad on a surface of the sealing layer away from the substrate, where the first metal column is electrically connected to the first metal pad, and the second metal column is electrically connected to the second metal pad.

In the first aspect or the second aspect, optionally, a material of the barrier layer is aluminum nitride, aluminum oxide, or silicon carbide.

In the first aspect or the second aspect, optionally, a width of the groove is less than 50 micrometers.

In the first aspect or the second aspect, optionally, a shape of the closed curve is a circle, an ellipse, a triangle, or a rectangle.

In the first aspect or the second aspect, optionally, a distance between an inner surface of the top wall and an upper surface of the resonance layer is greater than 2 micrometers and less than 100 micrometers, and a shortest distance between the inner surface of the side wall and the resonance layer is greater than 1 micrometer and less than 100 micrometers.

In the first aspect or the second aspect, optionally, the cavity is a vacuum.

In the first aspect or the second aspect, optionally, the cavity includes nitrogen, argon, helium, or neon.

In the first aspect or the second aspect, optionally, the resonator is a bulk acoustic wave BAW resonator.

According to a third aspect, a clock oscillator is provided. The clock oscillator includes the resonator according to any one of the first aspect or the possible implementations of the first aspect. Optionally, the clock oscillator is a bulk acoustic wave BAW resonator.

According to a fourth aspect, a component is provided. The component includes the resonator according to any one of the first aspect or the possible implementations of the first aspect. Optionally, the component is a chip.

According to a fifth aspect, an electronic device is provided. The electronic device includes the resonator according to any one of the first aspect or the possible implementations of the first aspect. Optionally, the electronic device is a communication device, a network device, or a terminal device.

Based on the foregoing solutions, the groove is machined on the sacrificial layer, and the barrier layer is formed on a surface of the sacrificial layer with the groove. In this way, in a process of removing the sacrificial layer to form the cavity, the etching material is prevented by using the barrier layer from entering the groove, so that the size of the cavity is precisely controlled, the complexity of the machining process of the resonator is reduced, the machining costs are reduced, and the reliability of the resonator is improved. Further, because the size of the cavity can be precisely controlled, a volume of the resonator can be further reduced.

### BRIEF DESCRIPTION OF DRAWINGS

FIG. 1 is a schematic diagram of a basic principle of a clock oscillator according to an embodiment of this application;
FIG. 2 is a schematic diagram of a basic structure of a resonator;
FIG. 3 is a schematic diagram of a structure of an oscillator including the resonator;
FIG. 4 is a vertical cross-sectional view of a resonator;
FIG. 5 is a vertical cross-sectional view of another resonator;
FIG. 6a and FIG. 6b are schematic diagrams of a structure of a resonator according to an embodiment of this application;
FIG. 7-1 to FIG. 7-12 are schematic diagrams of a preparation method for a resonator according to an embodiment of this application; and
FIG. 8 is a flowchart of a preparation method for a resonator according to an embodiment of this application.

### DESCRIPTION OF EMBODIMENTS

The following describes the technical solutions of this application in detail by using specific embodiments.

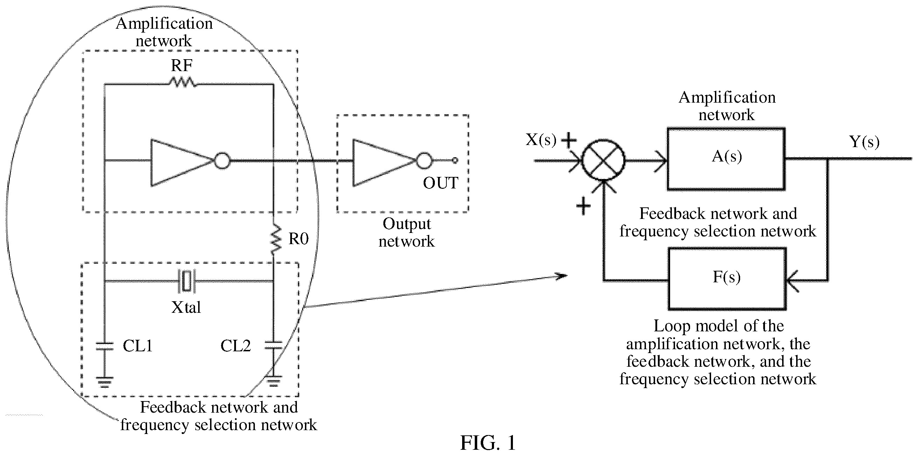

FIG. 1 is a schematic diagram of a basic principle of a clock oscillator. As shown in a left part of FIG. 1, the clock oscillator includes a resonator, a feedback network, a frequency selection network, an amplification network, and an output network. Refer to a loop model of the amplification network, the feedback network, and the frequency selection network in a right part of FIG. 1. The amplification network has a power gain. When the resonator starts to oscillate, the amplification network works in a linear region to amplify a noise signal or an input signal. During oscillation of the resonator, the amplification network enters a non-linear state, and a loop gain is decreased, to implement amplitude and frequency stabilization. The frequency selection network performs selection from frequency signals output by the amplification network, to cause a frequency signal at a selected frequency to be output, and signals at other frequencies to be suppressed. The feedback network feeds back the frequency signal through the frequency selection network to an input end of the amplification network to form a closed-loop positive feedback network. The output network shapes and drives an amplified stable frequency signal and outputs the amplified stable frequency signal to other components.

The resonator in the oscillator may be a microelectromechanical system (Microelectromechanical System, MEMS) resonator. The MEMS resonator may be a surface acoustic wave (surface acoustic wave, SAW) resonator, a bulk acoustic wave (bulk acoustic wave, BAW) resonator, or a silicon MEMS resonator.

A micro-nanostructure prepared based on a semiconductor process is also referred to as a semiconductor resonator. The semiconductor process has advantages of high process precision, a high degree of automation, and a high yield. A semiconductor resonator at a micrometer level is generally also a microelectromechanical system (Microelectromechanical System, MEMS) resonator.

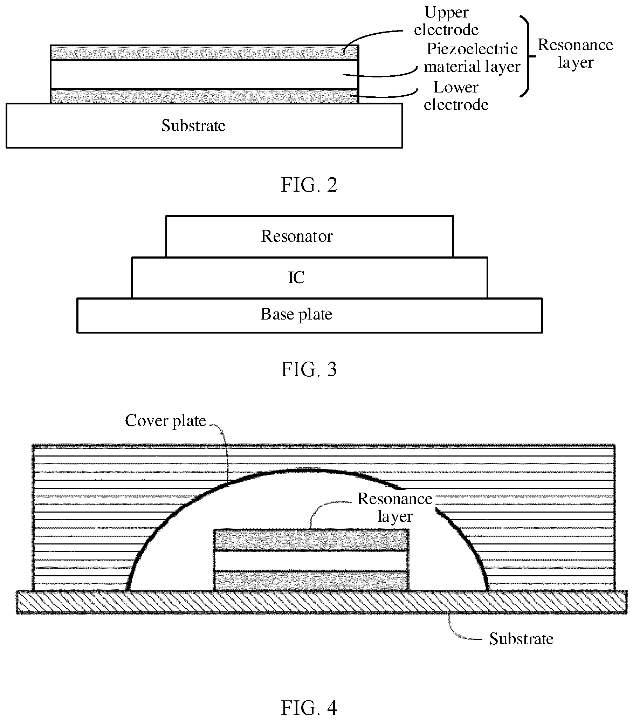

FIG. 2 is a schematic diagram of a basic structure of a resonator, and FIG. 3 is a schematic diagram of a structure of an oscillator including the resonator. As shown in FIG. 2, the resonator includes a resonance layer and a substrate. The resonance layer includes an upper electrode, a lower electrode, and a piezoelectric material layer. The piezoelectric material layer is sandwiched between the upper electrode and the lower electrode. An entirety formed by the three is placed on the substrate. The resonator further includes a cavity structure (not shown in FIG. 2) formed on the substrate. The cavity structure is configured to accommodate the resonance layer. Optionally, an acoustic mirror (acoustic mirror) may be further disposed between the lower electrode and the substrate. Optionally, the resonator is a BAW resonator. As shown in FIG. 3, the oscillator includes the resonator, an IC, and a base plate. The resonator and the IC are located on the base plate, and the IC is configured to control the resonator. Optionally, the oscillator is a BAW oscillator. A basic principle of the BAW oscillator is that an electric signal is converted into a sound wave by an electroacoustic transducer and transmitted in the piezoelectric material layer, the sound wave is reflected and resonates in a piezoelectric material, and finally the sound wave is converted into a high-frequency electric signal to form an oscillation signal.

In a possible implementation, a cavity structure of the resonance layer may be formed in a cap packaging manner, as shown in FIG. 4. FIG. 4 is a cross-sectional view of a resonator perpendicular to a plane on which a substrate is located, and may be referred to as a vertical cross-sectional view. The resonator includes a cover plate, a resonance layer, and the substrate. The cover plate includes a recessed portion. The cover plate and the substrate may be connected through a bonding process, so that the resonance layer is located in the recessed portion of the cover plate. The cover plate may be prepared from a silicon wafer. However, a structure shown in FIG. 4 has problems of a complex preparation process, a difficult machining process, and a poor sealing property.

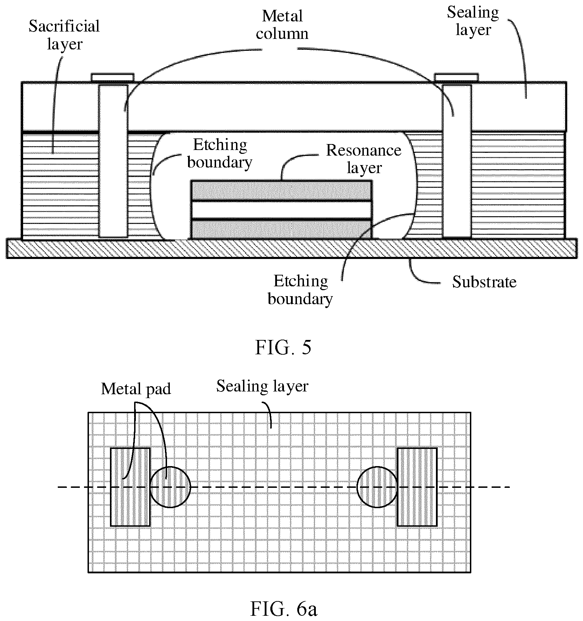

In another possible implementation, a cavity structure of the resonance layer may be formed in a thin film packaging manner, as shown in FIG. 5. A resonator shown in FIG. 5 includes a sealing layer, a sacrificial layer, a resonance layer, and a substrate. The resonance layer is formed on the substrate, and then the resonance layer is packaged in the sacrificial layer. The sealing layer is formed on the sacrificial layer. The sealing layer includes an etching through hole (not shown in FIG. 5). The sacrificial layer is etched by injecting an etching material through the etching through hole, to form a cavity structure, as shown in FIG. 5. The sealing layer may also be referred to as a thin film layer, and a preparation material is, for example, polysilicon. In a structure shown in FIG. 5, the etching through hole needs to be machined on the sealing layer having a specific thickness, and it is difficult to control a process of etching the sacrificial layer. As a result, a size of the cavity cannot be precisely controlled. Moreover, it is difficult to ensure reliability of the resonator shown in FIG. 5. For example, the resonator further includes metal columns. The metal columns are configured to implement electrical connections to an upper electrode and a lower electrode of the resonance layer, to drive the resonator. In a process of etching the sacrificial layer to form the cavity structure, it is difficult to control a location of an etching boundary. For example, the etching boundary extends beyond an edge of the metal column, causing the metal column to be etched by the etching material, and even causing a perforation on a side wall of the sacrificial layer, and causing a sealing failure of the cavity. Consequently, the resonator may work in an unstable state, reducing reliability of the resonator.

For the foregoing problems, this application provides a corresponding solution. Embodiments of this application provide a resonator and a preparation method thereof. A groove is machined on a sacrificial layer, and then a barrier layer is formed on a surface of the sacrificial layer with the groove. In this way, in a process of removing the sacrificial layer to form a cavity, an etching material is prevented by using the barrier layer from entering the groove, so that a size of the cavity is precisely controlled, complexity of a machining process of the resonator is reduced, machining costs are reduced, and reliability of the resonator is improved. Further, because the size of the cavity can be precisely controlled, a volume of the resonator can be further reduced.

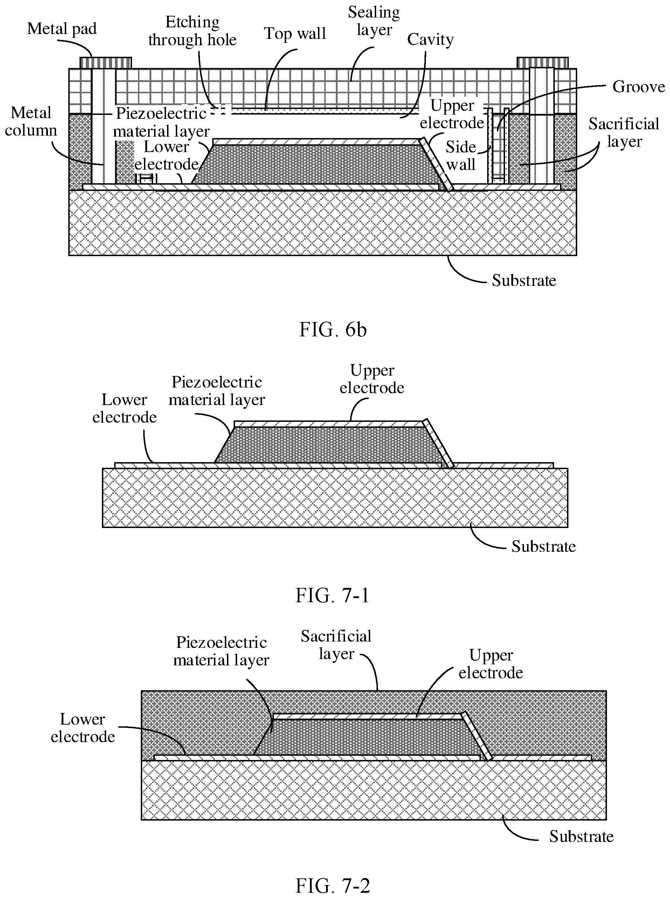

FIG. 6a and FIG. 6b are schematic diagrams of a structure of a resonator according to an embodiment of this application. Specifically, FIG. 6a is a top view of the resonator, and FIG. 6b is a vertical cross-sectional view of the resonator, that is, a cross-sectional view along a dashed line in FIG. 6a and perpendicular to a plane on which a substrate is located. Optionally, the resonator is a BAW resonator.

As shown in FIG. 6b, the resonator includes a resonance layer, a substrate, and a barrier layer. The barrier layer is located on the substrate, and the barrier layer and the substrate form a cavity. The cavity is configured to accommodate the resonance layer. The resonance layer includes an upper electrode, a piezoelectric material layer, and a lower electrode. The barrier layer includes a top wall and a side wall, and an inner surface of the side wall surrounds the resonance layer. The inner surface of the side wall is a surface of the side wall facing the cavity. Correspondingly, an outer surface of the side wall includes a groove, and the groove surrounds the side wall. The outer surface of the side wall is a surface of the side wall facing the groove. In other words, the groove is a closed curved surface relative to the side wall and the cavity. A trace of the groove is a closed curve in a direction from the top wall toward the substrate. Therefore, a trace of the side wall is a closed curve in the direction from the top wall toward the substrate. The trace refers to as a track line. A shape of the closed curve is, for example, a circle, an ellipse, a triangle, or a rectangle. For example, if the closed curve is a circle, the groove may be referred to as an annular groove. In this way, the resonance layer is surrounded by the annular groove. In addition, a trace on a bottom surface of the groove shown in FIG. 6b is a straight line. Optionally, the trace on the bottom surface of the groove may be arc-shaped or conical.

The groove is obtained by etching the sacrificial layer. Specifically, the sacrificial layer is deposited on the substrate, where a deposition thickness is greater than a height of the resonance layer, so that the resonance layer is packaged in the sacrificial layer. A material of the sacrificial layer may be silicon oxide (SiO₂) or polysilicon. Then, the groove is etched on the sacrificial layer. A depth of the groove is equal to a thickness of the sacrificial layer. In other words, the groove passes through the sacrificial layer. A width of the groove is less than 50 micrometers and preferably ranges from 5 micrometers to 20 micrometers. A deposition process in this application may include chemical vapor deposition and physical vapor deposition. The physical vapor deposition includes processes such as evaporation, sputtering, ion plating, and molecular beam epitaxy.

The barrier layer is formed on an outer surface of the sacrificial layer with the groove, as shown in FIG. 6b. Specifically, a barrier material may be deposited on a surface of the sacrificial layer to form the barrier layer. The formed barrier layer includes at least an upper surface formed on the sacrificial layer, as the top wall, and an inner surface formed on the groove adjacent to the cavity, as the side wall. Optionally, the barrier material is deposited on the inner surface of the groove. The barrier material is aluminum nitride (AlN), aluminum oxide (Al₂O₃), or silicon carbide (SiC). The sacrificial layer is configured to form the cavity, and the side wall is configured to prevent an etching material from entering the groove.

To etch the sacrificial layer surrounded by the top wall and the side wall of the barrier layer, the top wall of the barrier layer includes at least one etching through hole. A depth of the etching through hole is equal to a thickness of the top wall of the barrier layer. A diameter of the etching through hole is less than 5 micrometers. The sacrificial layer surrounded by the top wall and the side wall is etched by injecting the etching material through the etching through hole. After the sacrificial layer surrounded by the top wall and side wall is removed, the cavity is formed, as shown in FIG. 6. Optionally, the cavity is a vacuum. Optionally, the cavity includes nitrogen, argon, helium, or neon. In an implementation of etching the sacrificial layer, dry etching or wet etching may be used. The piezoelectric material layer is not in contact with the inner surface of the side wall. A distance between an inner surface of the top wall and an upper surface of the resonance layer is greater than 2 micrometers and less than 100 micrometers, and a shortest distance between the inner surface of the side wall and the resonance layer is greater than 1 micrometer and less than 100 micrometers. That is, a shortest distance between the inner surface of the side wall and the piezoelectric material layer is greater than 1 micrometer and less than 100 micrometers.

As shown in FIG. 6a and FIG. 6b, the resonator further includes a sealing layer, and the sealing layer is formed on an outer surface of the barrier layer. The sealing layer may be formed on the outer surface of the barrier layer through a deposition process. A material of the sealing layer may be silicon oxide, silicon nitride (Si₃N₄), polysilicon, or amorphous silicon. Optionally, the groove may be filled with the material of the sealing layer, or may be filled with other materials.

As shown in FIG. 6b, the resonator further includes metal columns and metal pads. Specifically, the metal columns include a first metal column and a second metal column, and the metal pads include a first metal pad and a second metal pad. The first metal column and the second metal column are located on the substrate. In addition, the first metal column and the second metal column are located outside the groove. A distance between the first metal column and an outer surface of the groove is greater than 1 micrometer, and preferably ranges from 5 micrometers to 30 micrometers. A distance between the second metal column and the outer surface of the groove is greater than 1 micrometer, and preferably ranges from 5 micrometers to 30 micrometers. A lead wire of the lower electrode passes through the side wall and is electrically connected to the first metal column, and a lead wire of the upper electrode passes through the side wall and is electrically connected to the second metal column. The first metal column passes through the sacrificial layer and the sealing layer, and is electrically connected to the first metal pad on a surface of the sealing layer. The second metal column passes through the sacrificial layer and the sealing layer, and is electrically connected to the second metal pad on the surface of the sealing layer. Materials of the first metal column, the second metal column, the first metal pad, and the second metal pad may include at least one of the following metals: aurum (Au), argentum (Ag), aluminum (Al), cuprum (Cu), molybdenum (Mo), stannum (Sn), indium (In), nickel (Ni), platinum (Pt), titanium (Ti), tantalum (Ta), and chromium (Cr).

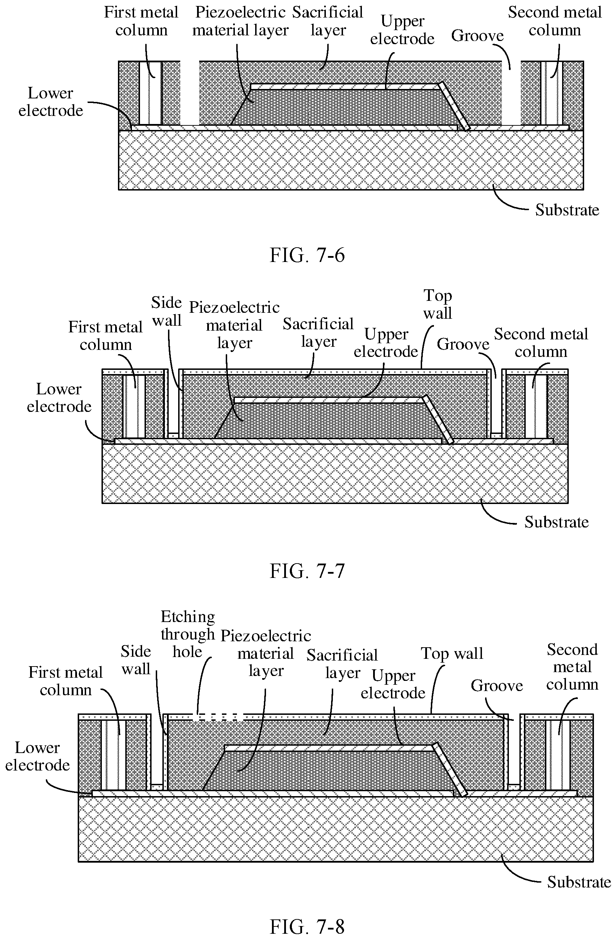

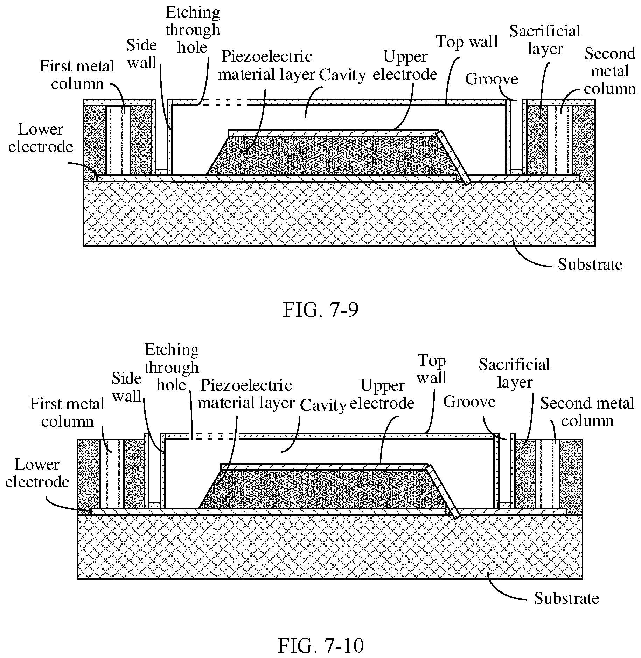

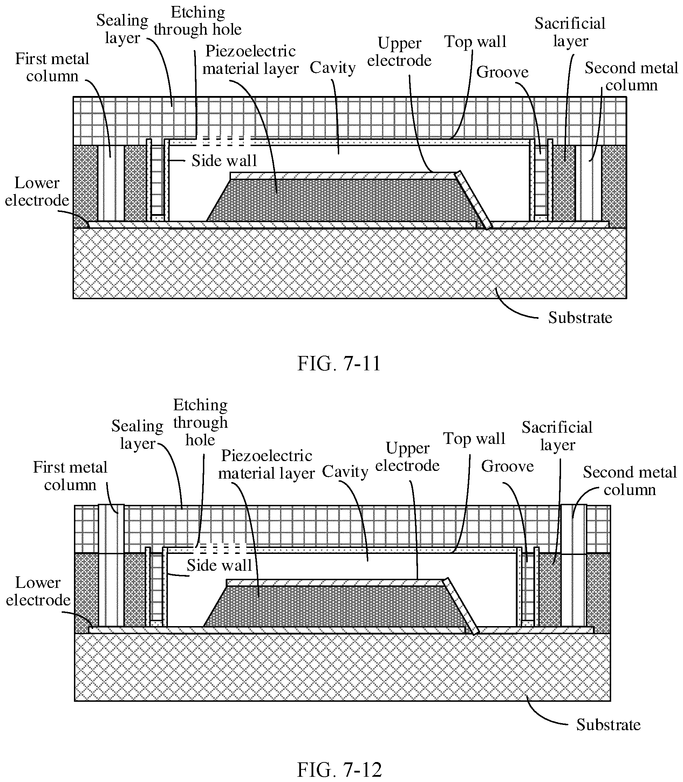

FIG. 7-1 to FIG. 7-12 are schematic diagrams of a preparation method for a resonator according to an embodiment of this application. FIG. 7-1 to FIG. 7-12 are vertical cross-sectional views of the resonator. Similarly, for the vertical cross-sectional views of FIG. 7-1 to FIG. 7-12, refer to the dashed lines in FIG. 6a. Optionally, the resonator is a BAW resonator. The following describes the preparation method for a resonator in this application with reference to FIG. 7-1 to FIG. 7-12.

Refer to FIG. 7-1. A resonance layer is machined on a substrate. The resonance layer includes an upper electrode, a piezoelectric material layer, and a lower electrode. A projection area of the resonance layer is less than a projection area of the substrate. Specifically, the resonance layer may be formed through a surface micro-machining process.

Refer to FIG. 7-2. After the resonance layer is formed on the substrate, a sacrificial layer is formed on the substrate through a deposition process. The resonance layer is packaged in the sacrificial layer. Based on the foregoing descriptions, a material of the sacrificial layer may be silicon oxide (SiO₂) or polysilicon. A projection area of the sacrificial layer is greater than the projection area of the resonance layer. A thickness of the sacrificial layer is higher than a height of the resonance layer. Preferably, the thickness of the sacrificial layer causes a distance between an inner surface of a top wall of a barrier layer and an upper surface of the resonance layer to be greater than 2 micrometers and less than 100 micrometers

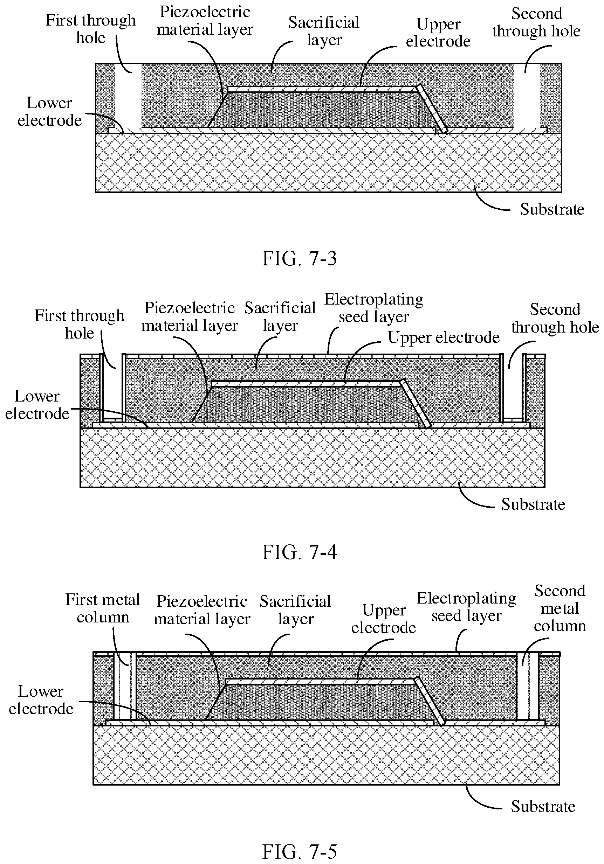

Refer to FIG. 7-3. A first through hole and a second through hole are machined on the sacrificial layer. Specifically, the first through hole and the second through hole may be machined through a dry etching process or a wet etching process. Hydrofluoric acid vapor is used as an etching material in the dry etching process. A hydrofluoric acid solution is used as an etching material in the wet etching process. Depths of the first through hole and the second through hole are consistent with the thickness of the sacrificial layer. The first through hole and the second through hole are used to obtain a first metal column and a second metal column. Diameters of the first through hole and the second through hole may range from 10 micrometers to 50 micrometers, and are preferably 30 micrometers. Different materials of the sacrificial layer correspond to different etching materials. For example, the etching material is hydrofluoric acid, the material of the sacrificial layer is SiO₂ or silicon nitride (SiNx), and a material of the barrier layer is aluminum nitride (AlN), aluminum oxide (Al₂O₃), silicon carbide (SiC), or polysilicon. For another example, the etching material is xenon difluoride, the material of the sacrificial layer is monocrystalline silicon, polysilicon, or amorphous silicon, and a material of the barrier layer silicon oxide (SiO₂), silicon nitride (SiNx), or silicon carbide (SiC).

Refer to FIG. 7-4. Metal layers are deposited on inner surfaces of the first through hole and the second through hole, and the metal layers are used as electroplating seed layers. The electroplating seed layers facilitate metal electroplating in the first through hole and the second through hole, to obtain the first metal column and the second metal column. Effective parts of the electroplating seed layers are electroplating seed layers formed on the inner surfaces of the first through hole and the second through hole. In a practical machining process, a simple processing manner may be used. For example, an electroplating seed layer is deposited on an outer surface of the sacrificial layer (as shown in FIG. 7-4). After obtaining the first metal column and the second metal column, excess electroplating seed layers are removed. A material of the electroplating seed layer may include at least one of the following metals: aurum (Au), argentum (Ag), aluminum (Al), cuprum (Cu), molybdenum (Mo), stannum (Sn), indium (In), nickel (Ni), platinum (Pt), titanium (Ti), tantalum (Ta), and chromium (Cr).

Refer to FIG. 7-5. Based on the electroplating seed layers, metal electroplating is performed in the first through hole and the second through hole, to obtain the first metal column and the second metal column. The first metal column is electrically connected to the lower electrode, and the second metal column is electrically connected to the upper electrode.

Refer to FIG. 7-6. Excess electroplating seed layers on the outer surface of the sacrificial layer are removed, and a groove is machined on the sacrificial layer. In a possible implementation, a width of the groove is uniform. For example, the width of the groove is a fixed value. For example, the width of the groove is less than 50 micrometers, and preferably ranges from 5 micrometers to 20 micrometers. A depth of the groove is consistent with the thickness of the sacrificial layer. An area surrounded by the groove is greater than the projection area of the resonance layer, that is, the resonance layer is surrounded by the groove. With reference to the foregoing descriptions, a trace of the groove is a closed curve in a direction from the top wall toward the substrate. A shape of the closed curve is, for example, a circle, an ellipse, a triangle, or a rectangle.

Refer to FIG. 7-7. The barrier layer is deposited on the outer surface of the sacrificial layer with the groove. In this way, a surface of the sacrificial layer away from the substrate and an inner surface of the groove are covered by a barrier material. The barrier material is aluminum nitride (AlN), aluminum oxide (Al₂O₃), or silicon carbide (SiC). Optionally, in a process of forming the barrier layer through machining, the barrier layer may not be formed on the inner surface of the groove away from the resonance layer or at the bottom of the groove. That is, during machining of the barrier layer, only a side wall and the top wall may be machined, as shown in FIG. 7-7. The distance between the inner surface of the top wall and the upper surface of the resonance layer is greater than 2 micrometers and less than 100 micrometers, and a shortest distance between an inner surface of the side wall and the resonance layer is greater than 1 micrometer and less than 100 micrometers.

Refer to FIG. 7-8. At least one etching through hole is machined on the top wall of the barrier layer. The etching through hole passes through the top wall for injecting the etching material, to etch the sacrificial layer surrounded by the side wall and the top wall. A quantity of etching through holes may be determined based on a volume of the sacrificial layer that needs to be etched. A diameter of the etching through hole may be less than 5 micrometers.

Refer to FIG. 7-9. The sacrificial layer surrounded by the side wall and the top wall is etched based on the dry etching process or the wet etching process. After an etching process is completed, the sacrificial layer surrounded by the side wall and the top wall is removed, to form a cavity. The cavity is configured to accommodate the resonance layer. The barrier material is corrosion resistant, blocks oxide etching, and effectively prevents the etching material from entering the groove. In this way, a space size of the cavity can be precisely controlled, and a case in which the resonator is unreliable is avoided. Optionally, the cavity is a vacuum. Optionally, the cavity includes nitrogen, argon, helium, or neon.

Refer to FIG. 7-10. A barrier layer on a surface of a remaining sacrificial layer is removed, and a barrier layer on an upper end surface of the first metal column and a barrier layer on an upper end surface of the second metal column are removed. Specifically, an etching process may be used to remove the excess barrier layer.

Refer to FIG. 7-11. A sealing layer is formed on an outer surface of the top wall, and the sealing layer covers the surface of the remaining sacrificial layer, the upper end surface of the first metal column, and the upper end surface of the second metal column. A material of the sealing layer may be silicon oxide, silicon nitride (Si₃N₄), polysilicon, or amorphous silicon. Optionally, the groove may be filled with the material of the sealing layer, or may be filled with other materials.

Refer to FIG. 7-12. A third through hole and a fourth through hole (not shown in FIG. 7-12) are machined on a surface of the sealing layer. A location of the third through hole is consistent with that of the first through hole, and a location of the fourth through hole is consistent with that of the second through hole. In addition, a diameter of the third through hole is equal to the diameter of the first through hole, and a diameter of the fourth through hole is equal to the diameter of the second through hole. Based on the foregoing descriptions, electroplating seed layers are deposited on inner surfaces of the third through hole and the fourth through hole. Then, metal electroplating is performed in the third through hole and the fourth through hole, to cause the first metal column and the second metal column to extend to an upper surface of the sealing layer.

Refer to FIG. 6b. Metal pads are machined on the surface of the sealing layer. The metal pads include a first metal pad and a second metal pad. The first metal pad is electrically connected to the first metal column, and the second metal pad is electrically connected to the second metal column. Materials of the first metal column, the second metal column, the first metal pad, and the second metal pad may include at least one of the following metals: aurum (Au), argentum (Ag), aluminum (Al), cuprum (Cu), molybdenum (Mo), stannum (Sn), indium (In), nickel (Ni), platinum (Pt), titanium (Ti), tantalum (Ta), and chromium (Cr).

Optionally, the upper electrode may include an etching resist layer, to prevent the upper electrode from being etched by the etching material. Similarly, the lower electrode and the piezoelectric material layer may also include etching resist layers.

Optionally, an upper surface of the substrate may include an etching resist layer, to prevent the upper electrode from being etched by the etching material.

In a possible implementation, the upper electrode, the lower electrode, the piezoelectric material layer, and the etching resist layer of the substrate may be completed before the machining process in FIG. 7-1. In other words, before the resonance layer is formed on the substrate, the etching resist layers are machined through deposition separately for the upper electrode, the lower electrode, the piezoelectric material layer, and the substrate.

In another possible implementation, refer to FIG. 7-2. Before the sacrificial layer is formed, the etching resistance layers are machined through deposition on the substrate with the resonance layer, so that the etching resist layers are formed on the upper electrode, the lower electrode, the piezoelectric material layer, and the surface of the substrate.

Based on the foregoing implementations, the groove is machined on the sacrificial layer, and then the barrier layer is formed on the surface of the sacrificial layer with the groove. In this way, in a process of removing the sacrificial layer to form the cavity, the etching material is prevented by using the barrier layer from entering the groove, so that the size of the cavity is precisely controlled, complexity of the machining process of the resonator is reduced, machining costs are reduced, and reliability of the resonator is improved. Further, because the size of the cavity can be precisely controlled, a volume of the resonator can be further reduced.

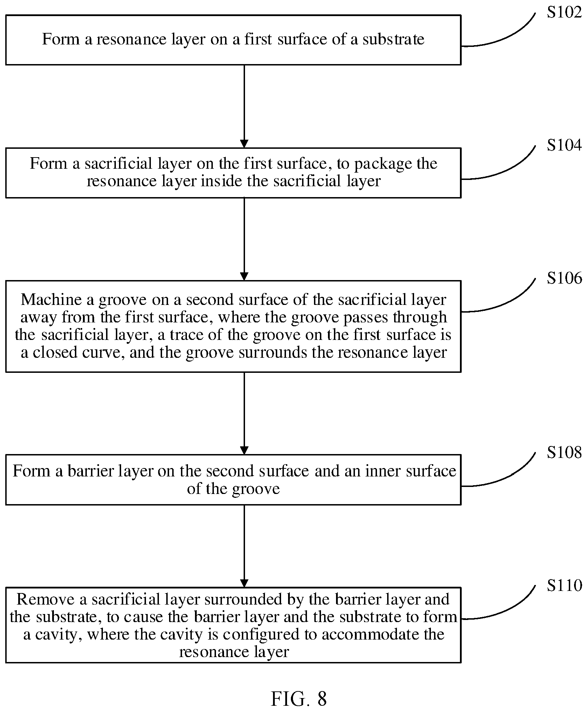

FIG. 8 is a flowchart of a preparation method for a resonator according to an embodiment of this application. As shown in FIG. 8, the preparation method includes the following steps:
S102. Form a resonance layer on a first surface of a substrate.
S 104. Form a sacrificial layer on the first surface, to package the resonance layer inside the sacrificial layer.
S106. Machine a groove on a second surface of the sacrificial layer away from the first surface, where the groove passes through the sacrificial layer, a trace of the groove on the first surface is a closed curve, and the groove surrounds the resonance layer.
S108. Form a barrier layer on the second surface and an inner surface of the groove.
S110. Remove a sacrificial layer surrounded by the barrier layer and the substrate, to cause the barrier layer and the substrate to form a cavity, where the cavity is configured to accommodate the resonance layer.

Optionally, the barrier layer includes a top wall and a side wall, and the side wall is configured to prevent an etching material from entering the groove.

In a possible implementation, at least one etching through hole is machined on the barrier layer. The removing a sacrificial layer surrounded by the barrier layer and the substrate specifically includes: etching, through the at least one etching through hole, the sacrificial layer surrounded by the barrier layer and the substrate.

Optionally, a material of the barrier layer is aluminum nitride, aluminum oxide, or silicon carbide.

Optionally, a material of the sacrificial layer is easier to be etched than the material of the barrier layer. To describe this characteristic, an etching selection ratio may be introduced. The etching selection ratio reflects a degree to which an etching rate of one material increases compared to another material under a same etching condition. Specifically, a value of the etching selection ratio is equal to a ratio of an etching rate of the material of the sacrificial layer to an etching rate of the material of the barrier layer. For example, the value of the etching selection ratio is 100:1. It indicates that the etching rate of the material of the sacrificial layer is 100 times that of the material of the barrier layer. In this way, it is ensured that the barrier layer is not damaged by the etching material.

Optionally, a shape of the closed curve is a circle, an ellipse, a triangle, or a rectangle.

Optionally, a width of the groove is less than 50 micrometers.

Optionally, the resonance layer includes an upper electrode, a piezoelectric material layer, and a lower electrode.

In a possible implementation, a first metal column and a second metal column are machined on the substrate, the first metal column and the second metal column are located outside the groove, a lead wire of the upper electrode passes through the barrier layer and is electrically connected to the second metal column, and a lead wire of the lower electrode passes through the barrier layer and is electrically connected to the first metal column.

In a possible implementation, a sealing layer is formed on an outer surface of the barrier layer.

In a possible implementation, a first metal pad and a second metal pad are machined on a surface of the sealing layer away from the substrate, the first metal column is electrically connected to the first metal pad, and the second metal column is electrically connected to the second metal pad.

Optionally, a distance between an inner surface of the top wall and an upper surface of the resonance layer is greater than 2 micrometers and less than 100 micrometers, and a shortest distance between an inner surface of the side wall and the resonance layer is greater than 1 micrometer and less than 100 micrometers.

Optionally, the cavity is a vacuum.

Optionally, the cavity includes nitrogen, argon, helium, or neon.

Optionally, the resonator is a BAW resonator.

Based on the foregoing implementations, the groove is machined on the sacrificial layer, and then the barrier layer is formed on a surface of the sacrificial layer with the groove. In this way, in a process of removing the sacrificial layer to form the cavity, the etching material is prevented by using the barrier layer from entering the groove, so that a size of the cavity is precisely controlled, complexity of a machining process of the resonator is reduced, machining costs are reduced, and reliability of the resonator is improved. Further, because the size of the cavity can be precisely controlled, a volume of the resonator can be further reduced.

An embodiment of this application provides a clock oscillator. The clock oscillator includes the resonator described in the foregoing embodiments.

Optionally, the clock oscillator is a BAW resonator.

An embodiment of this application provides a component. The component includes the resonator described in the foregoing embodiments. The component may be a chip.

An embodiment of this application provides an electronic device. The electronic device includes the resonator described in the foregoing embodiments. Specifically, the electronic device may be a communication device, a network device, or a terminal device, for example, a router, a switch, or another forwarding device; or the electronic device may be a computer device, for example, a personal computer or a server; or the electronic device may be a communication terminal device, for example, a mobile phone or a wearable intelligent device.

In this application, terms such as "first" and "second" are used to distinguish between same items or similar items that have basically same functions. It should be understood that "first", "second", and "n-th" do not have a logical or time sequential dependency relationship, and do not limit the quantity and execution sequence. It should also be understood that although terms such as "first" and "second" are used to describe various elements in the following description, these elements are not to be limited to these terms. These terms are merely used to distinguish one element from another element. For example, a first image may be referred to as a second image, and similarly, a second image may be referred to as a first image without departing from the scope of the various examples. Both the first image and the second image may be images, and in some cases, may be separate and different images.

It should be further understood that sequence numbers of the processes do not mean execution sequences in various embodiments of this application. The execution sequences of the processes should be determined based on functions and internal logic of the processes, and should not be construed as any limitation on implementation processes of embodiments of this application.

It should be understood that the terms used in descriptions of the various examples in this specification are merely for describing specific examples but are not intended to constitute a limitation. The terms "one" ("a" and "an") and "the" of singular forms used in the descriptions of the various examples and the appended claims are also intended to include plural forms, unless otherwise specified in the context clearly.

It should further be understood that the term "and/or" used in this specification indicates and includes any or all possible combinations of one or more of the associated listed items. The term "and/or" describes an association relationship for describing associated objects and represents that three relationships may exist. For example, A and/or B may represent the following three cases: Only A exists, both A and B exist, and only B exists. In addition, the character "/" in this application generally indicates an "or" relationship between the associated objects.

It should be further understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or their components not excluded.

It should be further understood that the term "if" may be interpreted as a meaning of "when" ("when" or "upon"), "in response to determining", or "in response to detecting". Similarly, according to the context, the phrase "if it is determined that" or "if (a stated condition or event) is detected" may be interpreted as a meaning of "when it is determined that" or "in response to determining" or "when (the stated condition or event) is detected" or "in response to detecting (the stated condition or event)".

It should be further understood that "an embodiment", "one embodiment", and "a possible implementation" mentioned throughout this specification mean that specific features, structures, or characteristics related to the embodiment or implementation are included in at least one embodiment of this application. Therefore, "in an embodiment", "in one embodiment", or "a possible implementation" in the entire specification may not necessarily refer to a same embodiment. In addition, these particular features, structures, or characteristics may be combined in one or more embodiments in any appropriate manner.

The objectives, technical solutions, and beneficial effects of this application are further described in detail in the foregoing specific implementations. It should be understood that the foregoing descriptions are merely specific implementations of this application.

## Claims

1. A resonator, wherein the resonator comprises a resonance layer and a substrate, wherein
the resonator further comprises a barrier layer, the barrier layer is located on the substrate, the barrier layer and the substrate form a cavity, and the cavity is configured to accommodate the resonance layer;
the barrier layer comprises a top wall and a side wall, and an inner surface of the side wall surrounds the resonance layer; and
an outer surface of the side wall comprises a groove, and the groove surrounds the side wall.

2. The resonator according to claim 1, wherein a trace of the groove is a closed curve in a direction from the top wall toward the substrate.

3. The resonator according to claim 2, wherein a shape of the closed curve is a circle, an ellipse, a triangle, or a rectangle.

4. The resonator according to any one of claims 1 to 3, wherein the side wall is obtained by machining a barrier material in the groove, the groove passes through a sacrificial layer between the top wall and the substrate, the sacrificial layer is configured to form the cavity, and the side wall is configured to prevent an etching material from entering the groove.

5. The resonator according to claim 4, wherein the barrier layer is obtained by depositing the barrier material on a surface of the sacrificial layer.

6. The resonator according to claim 4 or 5, wherein the barrier layer comprises at least one etching through hole, and the at least one etching through hole is used to etch the sacrificial layer.

7. The resonator according to any one of claims 4 to 6, wherein the barrier material is aluminum nitride, aluminum oxide, or silicon carbide.

8. The resonator according to any one of claims 1 to 7, wherein a width of the groove is less than 50 micrometers.

9. The resonator according to any one of claims 1 to 8, wherein a distance between an inner surface of the top wall and an upper surface of the resonance layer is greater than 2 micrometers and less than 100 micrometers, and a shortest distance between the inner surface of the side wall and the resonance layer is greater than 1 micrometer and less than 100 micrometers.

10. The resonator according to any one of claims 1 to 9, wherein the resonance layer comprises an upper electrode, a piezoelectric material layer, and a lower electrode, the substrate comprises a first metal column and a second metal column, the first metal column and the second metal column are located outside the groove, a lead wire of the upper electrode passes through the side wall and is electrically connected to the second metal column, and a lead wire of the lower electrode passes through the side wall and is electrically connected to the first metal column.

11. The resonator according to claim 10, wherein the resonator further comprises a sealing layer, and the sealing layer is formed on an outer surface of the barrier layer.

12. The resonator according to claim 11, wherein
the first metal column passes through the sealing layer, and the first metal column is electrically connected to a first metal pad on a surface of the sealing layer away from the substrate; and
the second metal column passes through the sealing layer, and the second metal column is electrically connected to a second metal pad on the surface of the sealing layer away from the substrate.

13. The resonator according to any one of claims 10 to 12, wherein the piezoelectric material layer is not in contact with the inner surface of the side wall.

14. The resonator according to any one of claims 1 to 13, wherein the cavity is a vacuum.

15. The resonator according to any one of claims 1 to 13, wherein the cavity comprises nitrogen, argon, helium, or neon.

16. The resonator according to any one of claims 1 to 15, wherein the resonator is a bulk acoustic wave BAW resonator.

17. A preparation method for a resonator, wherein the method comprises:
forming a resonance layer on a first surface of a substrate;
forming a sacrificial layer on the first surface, to package the resonance layer inside the sacrificial layer;
machining a groove on a second surface of the sacrificial layer away from the first surface, wherein the groove passes through the sacrificial layer, a trace of the groove on the first surface is a closed curve, and the groove surrounds the resonance layer;
forming a barrier layer on the second surface and an inner surface of the groove; and
removing a sacrificial layer surrounded by the barrier layer and the substrate, to cause the barrier layer and the substrate to form a cavity, wherein the cavity is configured to accommodate the resonance layer.

18. The method according to claim 17, wherein the barrier layer comprises a top wall and a side wall, and the side wall is configured to prevent an etching material from entering the groove.

19. The method according to claim 18, wherein the method further comprises:
machining at least one etching through hole on the barrier layer; and
the removing a sacrificial layer surrounded by the barrier layer and the substrate specifically comprises: etching, through the at least one etching through hole, the sacrificial layer surrounded by the barrier layer and the substrate.

20. The method according to claim 18 or 19, wherein a material of the barrier layer is aluminum nitride, aluminum oxide, or silicon carbide.

21. The method according to any one of claims 17 to 20, wherein a shape of the closed curve is a circle, an ellipse, a triangle, or a rectangle.

22. The method according to any one of claims 17 to 21, wherein a width of the groove is less than 50 micrometers.

23. The method according to any one of claims 17 to 22, wherein the resonance layer comprises an upper electrode, a piezoelectric material layer, and a lower electrode, and the method further comprises:
machining a first metal column and a second metal column on the substrate, wherein the first metal column and the second metal column are located outside the groove, a lead wire of the upper electrode passes through the barrier layer and is electrically connected to the second metal column, and a lead wire of the lower electrode passes through the barrier layer and is electrically connected to the first metal column.

24. The method according to claim 23, wherein the method further comprises: forming a sealing layer on an outer surface of the barrier layer.

25. The method according to claim 24, wherein the method further comprises:
machining a first metal pad and a second metal pad on a surface of the sealing layer away from the substrate, wherein the first metal column is electrically connected to the first metal pad, and the second metal column is electrically connected to the second metal pad.

26. The method according to claim 18, wherein a distance between an inner surface of the top wall and an upper surface of the resonance layer is greater than 2 micrometers and less than 100 micrometers, and a shortest distance between an inner surface of the side wall and the resonance layer is greater than 1 micrometer and less than 100 micrometers.

27. The method according to any one of claims 17 to 26, wherein the cavity is a vacuum.

28. The method according to any one of claims 17 to 26, wherein the cavity comprises nitrogen, argon, helium, or neon.

29. The method according to any one of claims 17 to 28, wherein the resonator is a bulk acoustic wave BAW resonator.

30. A clock oscillator, wherein the clock oscillator comprises the resonator according to any one of claims 1 to 16.

31. The clock oscillator according to claim 30, wherein the clock oscillator is a bulk acoustic wave BAW resonator.

32. A component, wherein the component comprises the resonator according to any one of claims 1 to 16.

33. An electronic device, wherein the electronic device comprises the resonator according to any one of claims 1 to 16.

34. The electronic device according to claim 33, wherein the electronic device is a communication device, a network device, or a terminal device.
